# EUROPÄISCHE PATENTANMELDUNG

(11) **EP 1 653 792 A1**
(43) Veröffentlichungstag der Anmeldung: **03.05.2006**
(21) Anmeldenummer: 05108243.6
(22) Anmeldetag: 08.09.2005
(51) Int. Cl.: H05K 9/00, H05K 1/02

(54) **Vorrichtung zur Abschirmung elektrischer Schaltungen und Verfahren zu deren Herstellung**

(30) Priorität: 27.10.2004 DE 102004052187
(71) Anmelder: ROBERT BOSCH GMBH, 70442 Stuttgart (DE)
(72) Erfinder: Gottwald, Frank, 71287, Weissach (DE)

(57) **Zusammenfassung**

Vorrichtung zur Abschirmung elektrischer Schaltungen (7) auf einer Leiterplatte (1) und Verfahren zur Herstellung dieser Vorrichtung, indem ein elektrisch leitfähiger, wannenförmiger Abschirmdeckel (2) mit einer Leiterplatte (1) derart verbunden wird, dass der elektrisch leitfähige, wannenförmige Abschirmdeckel und die Leiterplatte eine elektrische Schaltung einschließen, wobei die Leiterplatte an der Befestigungsfläche, an der diese mit dem Abschirmdeckel verbunden ist, vertieft ist.

## Beschreibung

Die vorliegende Erfindung betrifft eine Vorrichtung zur Abschirmung elektrischer Schaltungen auf einer Leiterplatte und Verfahren zur Herstellung dieser Vorrichtung, indem ein elektrisch leitfähiger, wannenförmiger Abschirmdeckel mit einer Leiterplatte derart verbunden wird, dass der elektrisch leitfähige, wannenförmige Abschirmdeckel und die Leiterplatte eine elektrische Schaltung einschließen, wobei die Leiterplatte an der Befestigungsfläche, an der diese mit dem Abschirmdeckel verbunden ist, vertieft ist.

### Stand der Technik

Aus der DE 102 05 748 A1 ist eine Vorrichtung und ein Verfahren zum Frequenzabgleich einer Hochfrequenzschaltung bekannt, bei dem eine elektrische Schaltung mittels eines Abschirmdeckels auf einer Leiterplatte umschlossen wird, wobei der Abschirmdeckel auf die Leiterplatte aufgesetzt wird und durch Verschieben des Abschirmdeckels ein Frequenzabgleich vornehmbar ist. Nach erfolgtem Frequenzabgleich der elektrischen Schaltung wird der Abschirmdeckel, der auf der ebenen Leiterplatte aufliegt, fest mit der Leiterplatte verbunden.

### Kern und Vorteile der Erfindung

Der Kern der vorliegenden Erfindung ist es, eine Vorrichtung und ein Verfahren zur Herstellung dieser Vorrichtung anzugeben, bei dem mittels eines Abschirmdeckels eine elektrische Schaltung auf einer Leiterplatte eingeschlossen wird, wobei diese Vorrichtung auch bei einer nicht vollständig planen Leiterplatte ein Einstreuen von Störstrahlung an Leckstellen der Verbindung zwischen Abschirmdeckel und Leiterplatte verhindert wird.

Erfindungsgemäß wird dieses durch die Merkmale der unabhängigen Ansprüche gelöst. Vorteilhafte Weiterbildungen und Ausgestaltungen ergeben sich aus den Unteransprüchen.

Vorteilhafterweise ist hierbei, dass die Vertiefung in der Leiterplatte grabenförmig ist. Hierdurch ist es möglich, den Abschirmdeckel teilweise in der Leiterplatte zu versenken, wodurch bei einer gebogenen oder welligen Leiterplatte die Wahrscheinlichkeit von Leckstellen, bedingt durch die nicht planen Kontaktstellen zwischen Abschirmdeckel und Leiterplatte verhindert werden.

Weiterhin ist es vorteilhaft, dass die grabenförmige Vertiefung auf der Leiterplatte rechteckförmig verläuft. Das Vorsehen einer rechteckförmigen Vertiefung ist vorteilhaft, da der Abschirmdeckel eine rechteckige Grundfläche aufweist und damit die Kontaktflächen zwischen Abschirmdeckel und Leiterplatte einen rechteckförmigen Rahmen bilden. Durch das Vorsehen einer rechteckförmig verlaufenden, grabenförmigen Vertiefung in der Leiterplatte kann der Abschirmdeckel im Bereich der vollständigen Kontaktfläche zur Leiterplatte in diese versenkt werden und eine zuverlässige Abschirmwirkung erzielt werden.

Vorteilhafterweise weist die Vertiefung eine Kupferbeschichtung auf. Weiterhin ist es vorteilhaft, dass die Leiterplatte im Bereich des Abschirmdeckels, auf der dem Abschirmdeckel abgewandten Seite, eine flächige Kupferschicht aufweist. Durch die flächige Kupferschicht auf der dem Abschirmdeckel abgewandten Seite der Leiterplatte erreicht man, dass sowohl der wannenförmige Abschirmdeckel sowie die flächige Kupferschicht die elektrische Schaltung nahezu vollständig umschließen und auch eine Einstrahlung von elektromagnetischen Störungen oder eine Abstrahlung elektromagnetischer Störungen in allen Richtungen vermieden werden kann.

Weiterhin ist es vorteilhaft, dass die Kupferbeschichtung in der Vertiefung mit der Kupferschicht auf der dem Abschirmdeckel abgewandten Seite der Leiterplatte elektrisch leitend miteinander verbunden sind. Durch die Verbindung der Kupferschicht in der Vertiefung mit der Kupferschicht auf der dem Abschirmdeckel abgewandten Seite der Leiterplatte erreicht man bei montiertem Abschirmdeckel, dass die gesamte, käfigförmige Abschirmung der elektrischen Schaltung das gleiche elektrische Potenzial aufweist, wodurch die Abschirmwirkung verbessert wird.

Weiterhin ist es vorteilhaft, dass der Abschirmdeckel aus Metall besteht. Weiterhin kann es vorgesehen sein, anstatt dem Abschirmdeckel aus Metall einen Kunststoffdeckel vorzusehen, der mit einer Metallschicht überzogen ist. Diese Metallschicht kann beispielsweise durch Aufdampfen oder Lackieren kostengünstig hergestellt werden. Durch die Herstellung eines metallbeschichteten Kunststoffabschirmdeckels ist es weiterhin möglich, komplexe Formen dieses wannenförmigen Abschirmdeckels mittels eines Spritzgussverfahrens in Kunststoff herzustellen und diesen danach mit der Metallschicht zu versehen.

Vorteilhafterweise wird der Abschirmdeckel auf der Leiterplatte mit einem Klebstoff befestigt. Ein Verbinden des Abschirmdeckels mit der Leiterplatte mittels eines Klebstoffs erlaubt eine kostengünstige Herstellung. Ein Verlöten des Abschirmdeckels mit der Leiterplatte ist ebenfalls möglich. Insbesondere das Vorsehen eines elektrisch leitfähigen Klebstoffes führt dazu, dass der Abschirmdeckel und die auf der dem Abschirmdeckel abgewandten Seite der Leiterplatte vorgesehene Kupferschicht das gleiche Potential aufweisen.

Vorteilhafterweise wird die Vertiefung auf der Leiterplatte durch Ausfräsen hergestellt. Weiterhin ist es vorteilhaft, dass die Vertiefung in der Leiterplatte mit Kupfer beschichtet wird.

Besonders vorteilhaft ist es, dass mittels Durchkontaktierungen in der Vertiefung die Kupferschicht in der Vertiefung mit einer Kupferschicht die auf der dem Abschirmdeckel abgewandten Seite der Leiterplatte elektrisch verbunden wird. Insbesondere bei dicken Leiterplatten, oder bei Leiterplatten die mehrere miteinander verbundene Leiterplattenschichten aufweisen, die jeweils elektrische Leiterbahnen tragen kann eine Abschirmvorrichtung hergestellt werden, die die elektrische Schaltung ähnlich einem Faradayschen Käfig umschließt, jedoch im Bereich zwischen den Durchkontaktierungen die Möglichkeit von Anschlusskontaktierungen der abgeschirmten elektrischen Schaltung ermöglicht.

Vorteilhafterweise wird in die Vertiefung der Leiterplatte Klebstoff eingebracht und der Abschirmdeckel durch teilweises Versenken in die Vertiefung mit der Leiterplatte verklebt.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in den Zeichnungen.

### Zeichnungen

Nachfolgend werden Ausführungsbeispiele der Erfindung anhand von Zeichnungen erläutert. Es zeigen
- Figur 1: ein erstes Ausführungsbeispiel der erfmdungsgemäßen Vorrichtung,
- Figur 2: ein weiteres Ausfühnmgsbeispiel der erfindungsgemäßen Vorrichtung und
- Figur 3: einen Verfahrensablauf zur Herstellung der erfindungsgemäßen Vorrichtung.

### Beschreibung von Ausführungsbeispielen

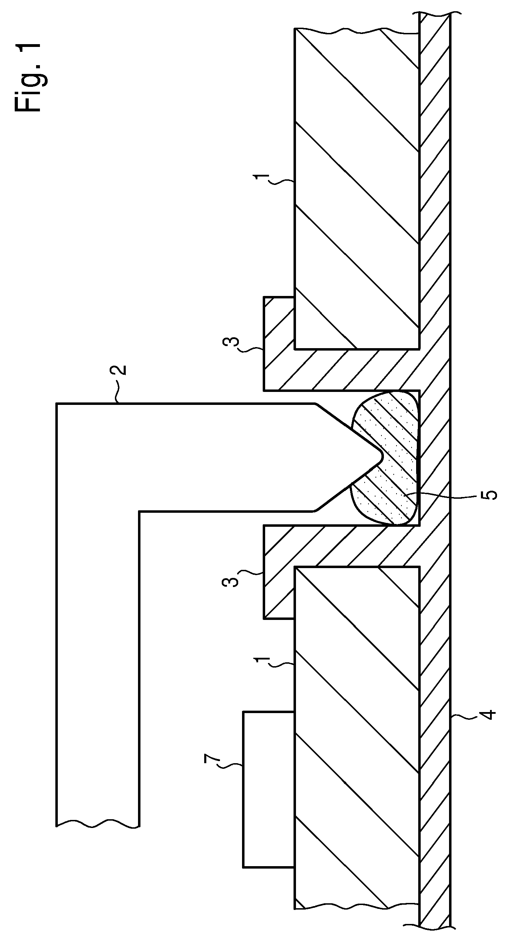

In Figur 1 ist eine Schnittdarstellung eines Ausschnitts der erfindungsgemäßen Vorrichtung dargestellt. Zu erkennen ist die Leiterplatte 1, die beispielsweise aus mehrere Leiterplattenlagen bestehen kann, wobei jede Leiterplattenlage elektrische Verbindungen aufweisen kann. Auf dieser Leiterplatte 1 sind elektrische Bauteile 7 aufgebracht, von denen beispielsweise ein Teil abgeschirmt werden muss, sodass keine elektromagnetische Störstrahlung auf diese Bauteile einwirkt bzw. diese Bauteile keine elektromagnetische Störstrahlung an ihre Umwelt abgeben. Hierzu ist ein elektrisch leitfähiger, meist wannenförmiger Abschirmdeckel 2 vorgesehen, der aus einer Grundplatte besteht, die an ihren Kanten wandartige, meist senkrecht abgewinkelte Fortsetzungen aufweist um die elektrischen Bauteile 7, die abzuschirmen sind, zu umschließen. Der in Figur 1 dargestellte Abschirmdeckel 2 ist hierbei nur teilweise dargestellt. Üblicherweise werden die Abschirmdeckel auf der Oberfläche der Leiterplatte 1 verlötet oder verklebt. Weist nun der Abschirmdeckel 2 eine nicht vollständig plane Randkante auf oder die Leiterplatte 1 eine Verbiegung oder Welligkeit auf, so kann es vorkommen, dass der Abschirmdeckel 2 nicht ringsum komplett auf der Leiterplatte 1 aufliegt, sondern Restöffnungen verbleiben, durch die Störstrahlung ein- oder austreten kann. Hierzu weist die Leiterplatte 1 in dem Bereich eine Vertiefung auf, in dem der Abschirmdeckel mit der Leiterplatte verbunden ist. Diese Vertiefung wurde mit einer Kupferschicht 3 ausgekleidet, sodass eventuell ein- oder ausfallende Störstrahlung zwischen dieser Kupferschicht 3 und dem Rand des Abschirmdeckels 2 nur mäanderförmig ein- oder ausfallen kann, wodurch eine hohe Abschirmwirkung dieser Vorrichtung erreicht wird. Weiterhin kann es vorgesehen sein, die Leiterplatte 1 auf der dem Abschirmdeckel 2 abgewandten Seite mit einer flächigen Kupferschicht 4 zu versehen, sodass auch Störstrahlung, die durch die Leiterplatte 1 hindurch ein- oder ausfallen kann, durch die flächige Kupferschicht 4 abgeschirmt wird. Um den Abschirmdeckel 2 dauerhaft mit der Leiterplatte 1 zu verbinden wird in die grabenförmige Vertiefung Klebstoff 5 eingebracht und anschließend der Abschirmdeckel 2 in die grabenförmige Vertiefung derart eingesetzt, dass dieser mit dem Klebstoff 5 Verbindung hat und die Leiterplatte 1 und der Abschirmdeckel 2 dauerhaft miteinander verbunden werden. Besonders vorteilhaft kann hierzu ein Klebstoff 5 verwendet werden, der elektrisch leitfähig ist und somit den Zwischenraum zwischen der Kupferschicht 3 der Vertiefung und dem Rand des Abschirmdeckels 2 mittels eines elektromagnetisch absorbierenden Mittels verschlossen wird. Im Fall, dass die Leiterplatte 1 gebogen ist oder eine Welligkeit aufweist oder dass der Rand des wannenförmigen Abschirmdeckels 2, der mit der Leiterplatte 1 verbunden wird, nicht ausreichend eben ist, kann durch die grabenförmige Verbindung diese Unebenheit oder Welligkeit ausgeglichen werden und eine Abschirmwirkung der elektrischen Bauteile 7 erreicht werden, die keinerlei Leckstellen für elektromagnetische Störstrahlung aufweist.

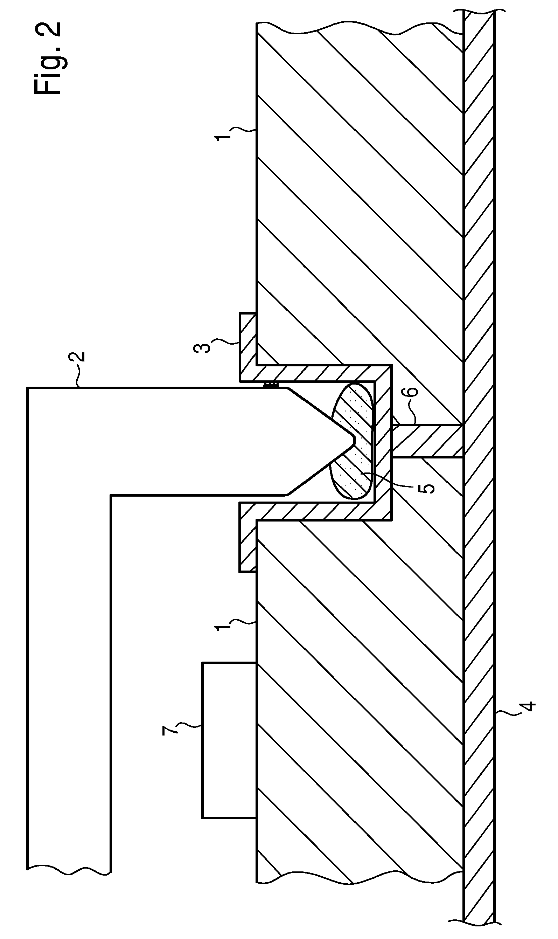

In Figur 2 ist eine weitere Ausgestaltung der Erfindung dargestellt, bei der wieder die Leiterplatte 1 dargestellt ist, die beispielsweise aus mehreren Leiteplattenschichten besteht und elektrische Bauteile 7 trägt. Weiterhin ist wieder der wannenförmige Abschirmdeckel 2 dargestellt, der abzuschirmende, elektrische Bauteile 7 vor einfallender Störstrahlung abschirmt oder durch diese Bauteile erzeugte Störstrahlung vor einer weiteren Ausbreitung abhält. In der Leiterplatte 1 ist wiederum im Bereich des Abschirmdeckelrandes eine Vertiefung vorgesehen, die mit einer Kupferschicht 3 versehen wurde. Die in Figur 2 dargestellte Vertiefung erstreckt sich im Gegensatz zur Vertiefung in Figur 1 nicht über die gesamte Dicke der Leiterplatte, sodass eine direkte Verbindung mit der flächigen Kupferschicht 4, die auf der dem Abschirmdeckel 2 abgewandten Seite der Leiterplatte 1 vorgesehen ist, nicht direkt in Verbindung steht. Hierzu sind zwischen dem Boden der Vertiefung und der flächigen Kupferschicht 4 auf der dem Abschirmdeckel 2 abgewandten Seite Verbindungslöcher 6 vorgesehen, die oftmals auch als Vias bezeichnet werden. Diese können beispielsweise mittels Durchkontaktierungen oder Bohrungen zwischen dem Boden der grabenförmigen Vertiefung und der gegenüberliegenden Seite gebohrt werden und danach mit Kupfer oder einem anderen, leitfähigen Material ausgefüllt werden. Hierdurch entsteht eine elektrisch leitende Verbindung zwischen der flächigen Kupferschicht 4 und der Kupferschicht 3, die die grabenförmige Vertiefung auskleidet. Zur festen Verbindung des Abschirmdeckels 2 mit der Leiterplatte 1 ist wiederum ein Klebstoff 5 vorgesehen, der in die grabenförmige Vertiefung eingebracht wird und die Leiterplatte 1 und den Abschirmdeckel 2 fest miteinander verbindet. Durch die Verbindungslöcher 6, die mit elektrisch leitendem Material ausgefüllt sind, sowie die Kupferschicht 3 in der grabenförmigen Vertiefung und den Klebstoff 5 bildet der elektrisch leitfähige Abschirmdeckel 2 mit der flächigen Kupferschicht 4 eine in allen Richtungen wirkende Abschirmung für elektromagnetische Strahlung, sodass die elektrischen Bauteile 7 innerhalb dieser Vorrichtung ähnlich wie in einem Faradayschen Käfig abgeschirmt sind. Hierdurch wird weiterhin erreicht, dass der Abschirmdeckel 2 sowie die gegenüberliegende flächige Kupferschicht 4 ein gemeinsames Potenzial aufweisen.

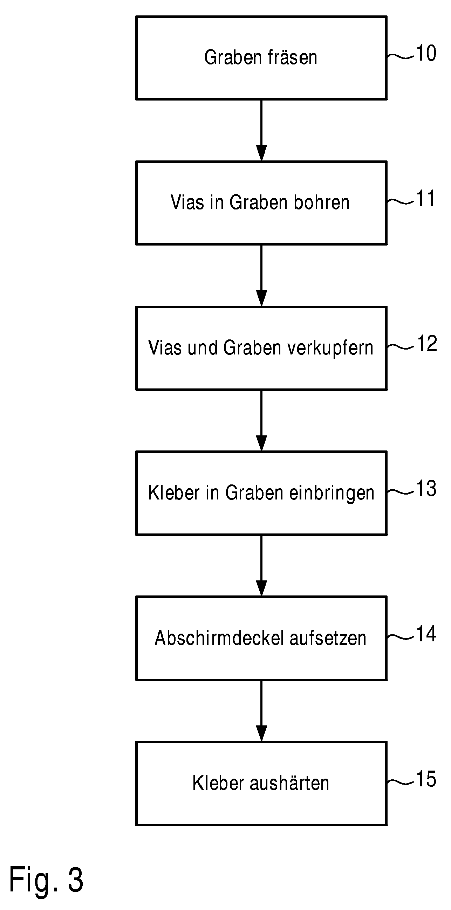

In Figur 3 ist ein Herstellungsverfahren zur Herstellung der erfindungsgemäßen Vorrichtung dargestellt. In die bereits strukturierte und eventuell schon bestückte Leiterplatte 1 werden mittels eine Fräskopfes grabenartige Vertiefungen gefräst, wie es in Schritt 10 dargestellt ist. Diese grabenartige Vertiefung weist hierbei die Form auf, die der Rand des Abschirmdeckels 2 aufweist, sodass dieser Rand des Abschirmdeckels 2 in die Vertiefung teilweise versenkbar ist. Diese grabenartige Vertiefung ist hierbei vorteilhafterweise rechteckförmig ausführbar, sodass ein rahmenförmiger Vertiefungsgraben entsteht, in den der meist rechtwinklige Abschirmdeckel 2 eingepasst werden kann. Anschließend werden in Schritt 11 Verbindungslöcher 6 gebohrt, die den Boden der grabenförmigen Vertiefung mit der gegenüberliegenden Leiterplattenseite verbinden. Im darauffolgenden Schritt 12 werden sowohl die Verbindungslöcher 6 sowie die Vertiefung verkupfert, sodass die Verbindungslöcher 6 mit elektrisch leitfähigem Material aufgefüllt werden und die grabenförmige Vertiefung eine Kupferschicht 3 aufweist. Danach wird gemäß Schritt 13 in die rahmenförmige, vorteilhafterweise rechteckförmige, grabenartige Vertiefung Klebstoff 5 eingebracht, wobei dieser Klebstoff vorteilhafterweise elektrisch leitfähig ist. Im darauffolgenden Schritt 14 wird der Abschirmdeckel in die Vertiefung eingesetzt und festgedrückt, sodass dieser den Klebstoff 5 berührt und den Zwischenraum zwischen dem Rand des Abschirmdeckels 2 und der Kupferschicht 3 der Vertiefung ausfüllt. Je nach verwendeter Klebstoffsorte kann es weiterhin notwendig sein, einen folgenden Schritt 15 vorzusehen, in dem der Klebstoff 5 ausgehärtet wird.

## Patentansprüche

1. Vorrichtung zur Abschirmung elektrischer Schaltungen (7) auf einer Leiterplatte (1), indem ein elektrisch leitfähiger, wannenförmiger Abschirmdeckel (2) mit einer Leiterplatte (1) derart verbunden wird, dass der elektrisch leitfähige, wannenförmige Abschirmdeckel (2) und die Leiterplatte (1) eine elektrische Schaltung (7) einschließen, **dadurch gekennzeichnet, dass** die Leiterplatte (1) an der Befestigungsfläche, an der diese mit dem Abschirmdeckel (2) verbunden ist, vertieft ist.

2. Vorrichtung nach Anspruch 1, **dadurch gekennzeichnet, dass** die Vertiefung in der Leiterplatte (1) grabenförmig ist.

3. Vorrichtung nach Anspruch 1 oder 2, **dadurch gekennzeichnet, dass** die grabenförmige Vertiefung auf der Leiterplatte (1) rechteckförmig verläuft.

4. Vorrichtung nach einem der vorhergehenden Ansprüche, **dadurch gekennzeichnet, dass** die Vertiefung eine Kupferbeschichtung (3) aufweist.

5. Vorrichtung nach einem der vorhergehenden Ansprüche, **dadurch gekennzeichnet, dass** die Leiterplatte (1) im Bereich des Abschirmdeckels (2), auf der dem Abschirmdeckel (2) abgewandten Seite, eine flächige Kupferschicht (4) aufweist.

6. Vorrichtung nach einem der vorhergehenden Ansprüche, **dadurch gekennzeichnet, dass** die Kupferbeschichtung (3) in der Vertiefung mit der Kupferschicht (4) auf der dem Abschirmdeckel (2) abgewandten Seite der Leiterplatte (1) elektrisch leitend miteinander verbunden sind.

7. Vorrichtung nach einem der vorhergehenden Ansprüche, **dadurch gekennzeichnet, dass** der Abschirmdeckel (2) aus Metall oder einem metallbeschichteten Kunststoff besteht.

8. Vorrichtung nach einem der vorhergehenden Ansprüche, **dadurch gekennzeichnet, dass** der Abschirmdeckel (2) auf der Leiterplatte (1) mit einem Klebstoff (5) befestigt ist.

9. Verfahren zur Herstellung einer Abschirmung für elektrischer Schaltungen (7), indem auf die Leiterplatte (1) ein elektrisch, leitfähiger, wannenförmiger Abschirmdeckel (2) derart aufgebracht wird, dass der elektrisch leitfähige, wannenförmige Abschirmdeckel (2) und die Leiterplatte (1) eine elektrische Schaltung (7) einschließen, **dadurch gekennzeichnet, dass** die Leiterplatte (1) an der Befestigungsfläche, an der der Abschirmdeckel (2) mit der Leiterplatte (1) verbunden ist, vertieft wird und die Befestigungsfläche des Abschirmdeckels (2) in der Vertiefung befestigt wird.

10. Verfahren nach Anspruch 9, **dadurch gekennzeichnet, dass** die Vertiefung durch Ausfräsen (10) der Leiterplatte (1) geschieht.

11. Verfahren nach Anspruch 9 oder 10, **dadurch gekennzeichnet, dass** die Vertiefung in der Leiterplatte (1) mit Kupfer beschichtet (12) wird.

12. Verfahren nach einem der Ansprüche 9 bis 11, **dadurch gekennzeichnet, dass** mittels Durchkontaktierungen (6) in der Vertiefung, die Kupferschicht (3) in der Vertiefung mit einer Kupferschicht (4), die auf der dem Abschirmdeckel (2) abgewandten Seite der Leiterplatte (1), elektrisch verbunden wird.

13. Verfahren nach einem der Ansprüche 9 bis 12, **dadurch gekennzeichnet, dass** in die Vertiefung der Leiterplatte (1) Klebstoff (5) eingebracht wird und der Abschirmdeckel (2) durch teilweises versenken in die Vertiefung mit der Leiterplatte (1) verklebt wird.
